# DEMANDE DE BREVET EUROPEEN

(11) **EP 2 299 791 A1**
(43) Date de publication de la demande: **23.03.2011**
(21) Numéro de dépôt: 10176300.1
(22) Date de dépôt: 10.09.2010
(51) Int. Cl.: H05K 1/02, H05K 1/11

(54) **Interconnexion pour circuit imprimé haute fréquence**

(30) Priorité: 11.09.2009 FR 0904348
(71) Demandeur: Thales, 92200 Neuilly Sur Seine (FR); Groupe des Ecoles des Telecommunications/ Ecole Nationale Superieure de Telecommunications De Bretagne, 29238 Brest Cedex 3 (FR)
(72) Inventeur: Cornic, Pascal, 29200 Brest (FR); Coupez, Jean-Philippe, 29480 Le Relecq Kerhuon (FR); Hemery, Jérémie, 29140 Tourc'h (FR); Boucher, Julien, 29450 Commana (FR)
(74) Mandataire: Collet, Alain

(57) **Abrégé**

L'invention concerne un circuit imprimé pour signaux haute fréquence et plus particulièrement des moyens d'interconnexion entre des lignes de transmission (13, 14) situées sur des faces différentes du circuit imprimé. Selon l'invention, au voisinage des moyens d'interconnexion (20, 21), les lignes de transmission (13, 14) s'étendent chacune selon une direction principale (22, 23). Les moyens d'interconnexion comprennent deux vias (20, 21) s'étendant chacun selon un axe (24, 25). Dans un plan contenant la direction principale (22, 23) d'une première des lignes de transmission (13, 14) et perpendiculaire à la face portant la première ligne de transmission (13), on forme un repère orthogonal dont l'abscisse est porté par la direction principale (22) de la première ligne de transmission (13). Les abscisses des axes (24, 25) des vias (20, 21) dans ce repère ou de leur projection sur le plan, perpendiculairement au plan, sont distinctes.

## Description

L'invention concerne un circuit imprimé pour signaux haute fréquence et plus particulièrement des moyens d'interconnexion entre des lignes de transmission situées sur des faces différentes du circuit imprimé. L'invention trouve une utilité particulière pour la transmission de signaux radiofréquence en bande X, en particulier pour des fréquences de 9 à 1OGHz. Il est bien entendu que l'invention peut s'appliquer à d'autres bandes de fréquence.

Pour véhiculer des signaux haute fréquence on utilise, par exemple, une technologie dite micro ruban réalisée sur circuit imprimé. Des pistes conductrices imprimées sont réalisées sur des faces du circuit imprimé. Ces faces peuvent être externes ou internes et peuvent être séparées par un ou plusieurs plans conducteurs. Les lignes micro rubans ont des dimensions particulières de telle sorte que, une fois associées aux plans conducteurs elles forment des lignes adaptées en impédance. Cette adaptation permet d'assurer une certaine transparence de la ligne vis-à-vis du signal véhiculé. En d'autres termes, on cherche à réduire au maximum les pertes de puissance électrique du signal tout au long de la ligne.

La ligne de transmission peut être amenée à changer de face du circuit imprimé. Pour se faire, on utilise des vias, également appelés trous métallisés, permettant d'assurer un contact électrique entre les pistes de différentes faces. Les vias sont généralement à section circulaire. Le mode de réalisation le plus simple de ces vias est le perçage du circuit imprimé suivi d'une métallisation de l'intérieur du trou.

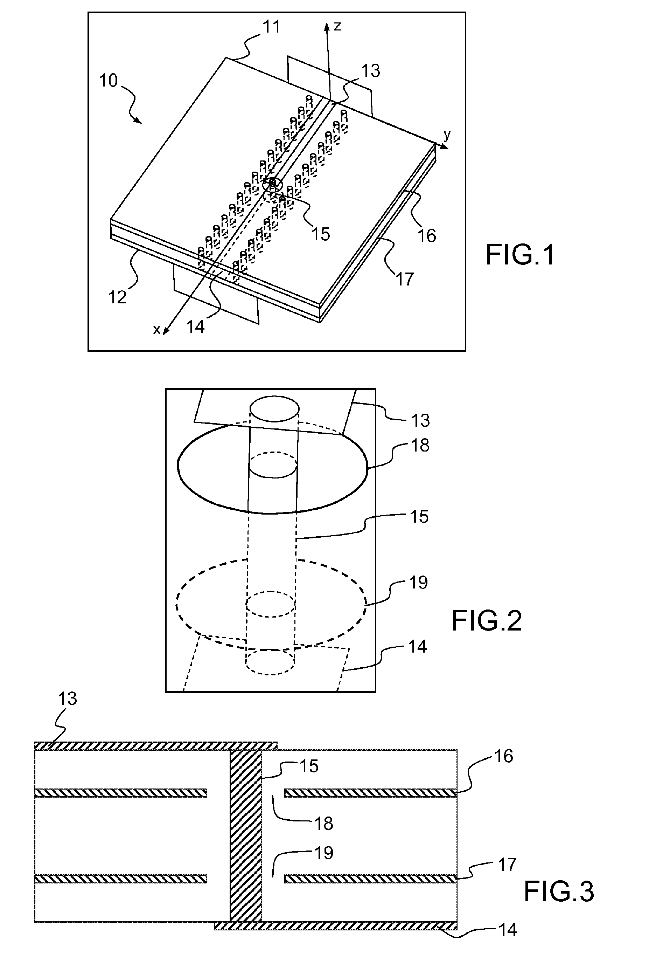

La figure 1 illustre cette réalisation dans un circuit imprimé 10 comprenant deux faces externes 11 et 12 portant chacune une ligne micro ruban, respectivement 13 et 14. Les deux lignes 13 et 14 sont interconnectées au moyen d'un via 15. La figure 2 représente une vue agrandie du circuit imprimé 10 autour du via 15 et la figure 3 représente le circuit imprimé 10 en coupe autour du via 15. Le circuit imprimé comprend également deux plans conducteurs 16 et 17. Autour du via 15, les deux plans conducteurs 16 et 17 sont interrompus pour former dans chacun une épargne, respectivement 18 et 19, au travers desquelles passe le via 15.

Un simple via d'interconnexion radiofréquence dans une structure multicouches, telle qu'illustrée sur les figure 1 à 3, présente des effets électriques parasites, qui viennent particulièrement casser la transparence du via vis à vis du signal véhiculé. Cette transparence est surtout dégradée en haute fréquence. Ces effets, notamment liés au caractère inductif intrinsèque au via 15, entraînent alors une désadaptation et des pertes d'insertion plus ou moins importantes sur le signal.

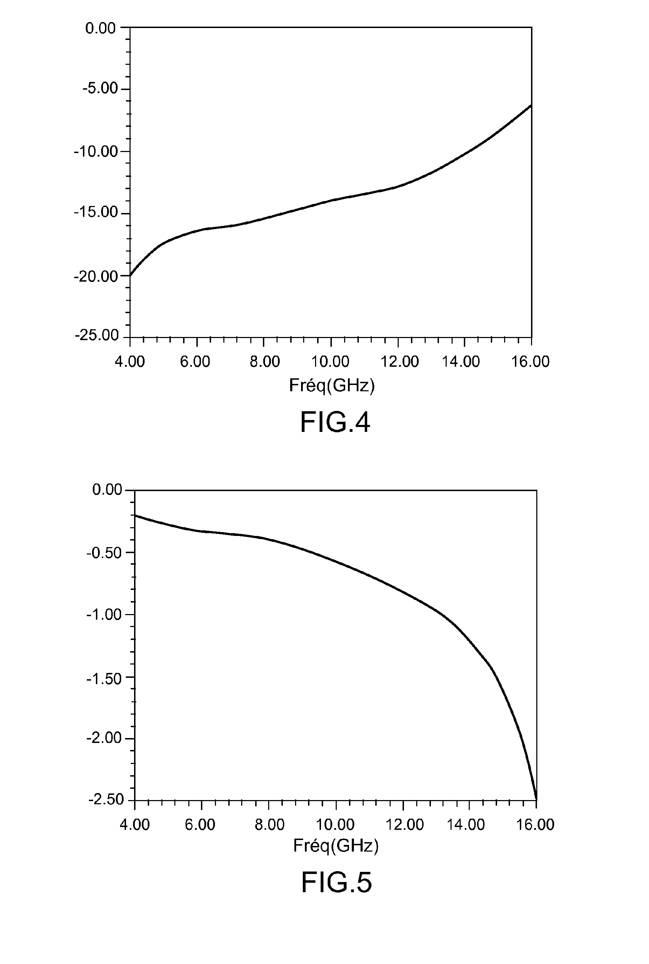

La figure 4 représente le niveau d'adaptation S11 de l'exemple représenté sur les figures 1 à 3 exprimé en dB en fonction de la fréquence du signal véhiculé par l'interconnexion. Le niveau d'adaptation illustre la puissance électrique réfléchie par l'interconnexion. Toujours pour cet exemple, la figure 5 représente le niveau d'insertion S21 ou perte d'insertion exprimé en dB en fonction de la fréquence du signal. Le niveau d'insertion illustre la perte de puissance électrique en transmission au niveau de l'interconnexion.

On constate, dans ce cas, que le via 15 présente un niveau d'adaptation de -14,5dB pour une fréquence utile de travail de 9.3GHz, et des pertes d'insertion de 0,49dB pour cette même fréquence. Etant donné ces résultats, l'interconnexion est loin d'être optimale.

L'invention vise à améliorer la transparence d'une interconnexion de type via dans un circuit imprimé entre deux lignes de transmission disposées sur différentes faces du circuit. L'invention cherche à augmenter le niveau d'adaptation et à réduire les pertes de transmission.

A cet effet, l'invention a pour objet un circuit imprimé pour signaux haute fréquence, comprenant au moins deux faces portant chacune au moins une ligne de transmission des signaux et des moyens d'interconnexion des lignes de transmission entre les deux faces,
**caractérisé en ce qu**'au voisinage des moyens d'interconnexion, les lignes de transmission s'étendent chacune selon une direction principale,
en ce que les moyens d'interconnexion comprennent deux vias s'étendant chacun selon un axe, une ligne de transmission d'une face étant reliée à une ligne de transmission d'une autre face au moyen des deux vias,
en ce que dans un plan contenant la direction principale d'une première des lignes de transmission et perpendiculaire à la face portant la première ligne de transmission, on forme un repère orthogonal dont l'abscisse est porté par la direction principale de la première ligne de transmission,
et en ce que les abscisses des axes des vias ou de leur projection sur le plan, perpendiculairement au plan, sont distinctes.

L'invention sera mieux comprise et d'autres avantages apparaîtront à la lecture de la description détaillée d'un mode de réalisation donné à titre d'exemple, description illustrée par le dessin joint dans lequel :
Les figures 1 à 3 représentent un circuit imprimé connu dans lequel un via permet l'interconnexion entre deux lignes de transmission disposées sur différentes faces du circuit ;
les figures 4 et 5 présentent des données chiffrées illustrant la transparence de l'interconnexion représentée aux figures 1 à 3 ;
la figure 6 représente un mode de réalisation testé par le déposant ;
les figures 7 et 8 présentent des données chiffrées illustrant la transparence de l'interconnexion représentée à la figure 6 ;
la figure 9 représente un mode de réalisation de l'invention;
les figures 10a et 10b représentent une variation de distance entre deux vias réalisant l'interconnexion de la figure 9 ;
les figures 11 et 12 présentent des données chiffrées illustrant la transparence de l'interconnexion représentée aux figures 9, 10a et 10b ;
les figures 13 et 14 présentent des données chiffrées illustrant la transparence de l'interconnexion pour la variation de diamètre de via.

Par souci de clarté, les mêmes éléments porteront les mêmes repères dans les différentes figures.

Les figures 1 à 5 ont déjà été décrites pour présenter l'invention.

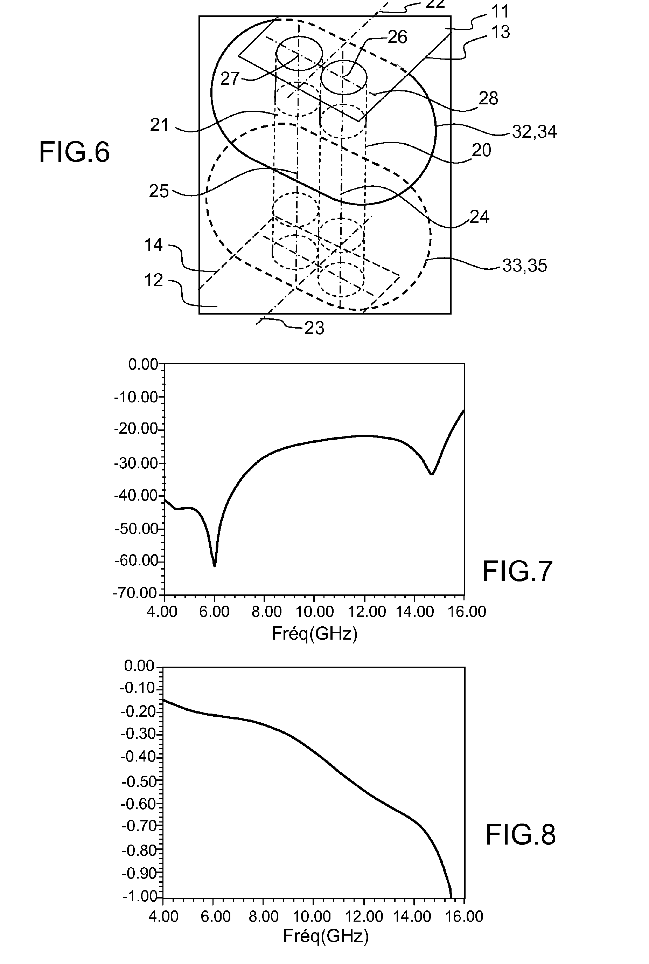

La figure 6 représente une vue agrandie du circuit imprimé 10 autour de l'interconnexion qui cette fois comprend deux vias 20 et 21 reliant les deux lignes de transmission 13 et 14 qui s'étendent chacune selon une direction principale, respectivement 22 et 23. Les directions principales appartiennent chacune au plan dans lequel les faces externes 11 et 12 du circuit imprimé s'étendent. Les deux vias 20 et 21 sont des trous métallisés à section tubulaires s'étendant chacun selon un axe respectivement 24 et 25. Les vias sont par exemple réalisés par perçage du circuit imprimé suivi d'une métallisation. Les vias 20 et 21 sont alors à section circulaire perpendiculairement à leur axe respectif 24 et 25. D'autres procédés d'usinage peuvent remplacer le perçage, comme par exemple la découpe laser. Par les deux intersections 26 et 27 des axes 24 et 25 avec le plan de la face 11 passe une droite 28 perpendiculaire à la direction principale 22. Dans ce mode de réalisation, les directions principales 22 et 23 sont parallèles.

Cette structure d'interconnexion à deux vias est dite structure à deux vias en parallèle permet d'améliorer la transparence de l'interconnexion. On a vu précédemment qu'un via possède essentiellement un caractère inductif entraînant des pertes dans l'interconnexion. En première approche, les deux vias en parallèle peuvent être modélisés par deux inductances en parallèle, ce qui apporte une meilleure transparence de l'interconnexion due à une inductance de l'interconnexion plus faible que pour un seul via. Dans la réalité, des couplages entre vias existent et les résultats d'une simulation électromagnétique sont présentés sur les figures 7 et 8. La figure 7 représente le niveau d'adaptation S11 de cette structure et la figure 8 représente le niveau d'insertion S21. A une fréquence de 9,3GHz, le niveau d'adaptation est de -24,5dB et les pertes d'insertion sont de 0,31 dB.

Les niveaux d'insertion et d'adaptation sont meilleurs que ceux mesurés avec un seul via. On cherche néanmoins à améliorer encore la transparence de l'interconnexion.

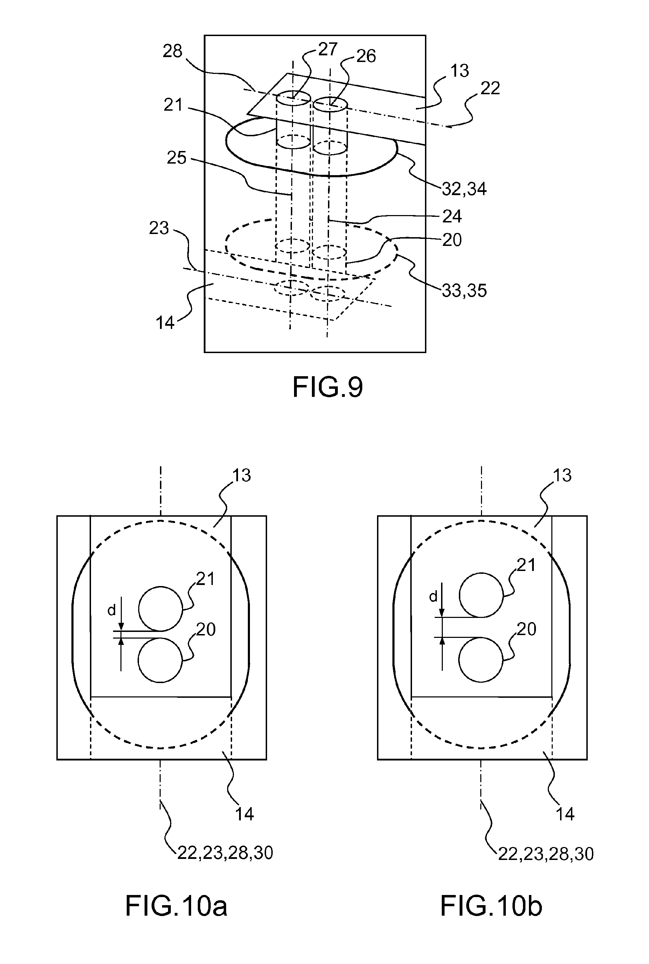

La figure 9 représente un second mode de réalisation permettant cette amélioration. Dans ce mode de réalisation, les vias ne sont plus en parallèle comme dans la figure 6. Sur la figure 9, les vias sont en cascade. Autrement dit, la droite 28 passant par les deux intersections 26 et 27 des axes 24 et 25 avec le plan de la face 11 n'est plus perpendiculaire à la direction principale 22. Dans l'exemple représenté sur la figure 9, la droite 28 est confondue avec la direction principale 22. Il est bien entendu possible de faire varier l'angle de la droite 28 et de la direction principale 22. On constate déjà une amélioration de la transparence de l'interconnexion dès que la droite 28 s'éloigne d'une direction perpendiculaire à la direction principale 22.

Autrement dit, dans un plan 30 contenant la direction principale 22 et perpendiculaire à la face 11, on forme un repère orthogonal dont l'abscisse est portée par la direction principale 22. Dans ce repère, les abscisses des axes 24 et 25 des vias 20 et 21 ou de leur projection sur le plan 30 perpendiculairement au plan 30 sont distinctes.

L'amélioration de la transparence est particulièrement intéressante lorsque les directions principales 22 et 23 des deux lignes de transmission 13 et 14 sont parallèles. Cette structure de vias en cascade présente également un avantage lorsqu'on est limité par la largeur des lignes de transmission. En effet, cette largeur est un paramètre important dans la définition de l'impédance caractéristique de la ligne de transmission. Le fait de placer deux vias en cascade permet de ne pas élargir la ligne de transmission pour y placer les deux vias 20 et 21.

L'invention n'est pas limitée à deux vias en cascade. On peut également réaliser l'interconnexion des deux lignes de transmission 13 et 14 au moyen de plus de deux vias qui, lorsqu'ils sont en cascade, ne dépasseront pas un volume défini par le recouvrement des deux lignes de transmission 13 et 14 lorsque les axes 22 et 23 sont parallèles.

Pour améliorer la transparence d'une interconnexion, les paramètres dimensionnels de l'interconnexion sont importants. Ces paramètres sont à adapter en fonction de la bande de fréquence du signal électrique. La structure de vias en cascade permet un grand choix de paramètres dimentionnels et dans une plus grande fourchette de variation que pour les vias en parallèle.

La distance entre deux vias forme un premier paramètre de réglage possible. Les figures 10a et 10b représentent une variation d'une distance d entre les deux vias 20 et 21 réalisant l'interconnexion de la figure 9. Ces deux figures sont représentées dans un plan perpendiculaire au plan 30 dont la trace apparaît sur ces figures en superposition des directions principales 22 et 23 ainsi que de la droite 28. Sur la figure 10a, la distance d est inférieure à celle représentée sur la figure 10b.

Dans un exemple numérique chiffré, à la fréquence de 9,3GHz, les lignes micro rubans ont une impédance de 50 Ω pour une largeur de 1,91 mm et pour un substrat de 0,813mm d'épaisseur et de permittivité relative égale à 3,38. Les deux vias 20 et 21 ont un diamètre de 600µm.

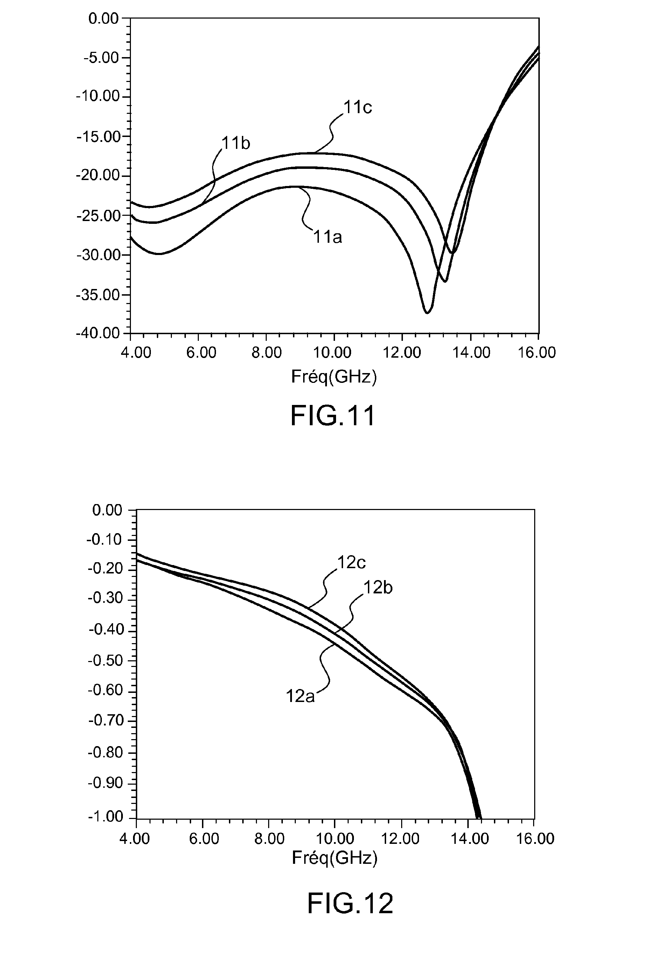

La figure 11 représente, pour cet exemple chiffré, le niveau d'adaptation S11 de l'interconnexion représentée sur la figure 9 en faisant varier la distance d. Plus précisément, la figure 11 est le résultat d'une simulation pour laquelle une courbe 11 a représente l'évolution du niveau d'adaptation S11 pour une distance d de 100µm séparant deux vias 20 et 21 de 600µm de diamètre chacun. Une courbe 11 b représente l'évolution du niveau d'adaptation S11 pour une distance d de 200µm séparant les deux mêmes vias et une courbe 11 c pour une distance d de 300µm.

La figure 12 représente, toujours pour le même exemple chiffré, le niveau d'insertion S21 avec trois courbes : 12a pour la distance d de 300µm; 12b pour la distance d de 200µm; 12c pour la distance d de 100µm.

Par exemple, pour une fréquence de 9,3GHz et une distance d de 100µm, le niveau d'adaptation est de -21,4dB les pertes d'insertion sont de 0.33dB. Pour cette même fréquence et la distance d de 200µm, le niveau d'adaptation est de -18,9dB et les pertes d'insertion sont de 0,36dB. Enfin, toujours à 9,3GHz, pour la distance d de 300µm, le niveau d'adaptation est de -17dB et les pertes d'insertion sont de 0,39dB.

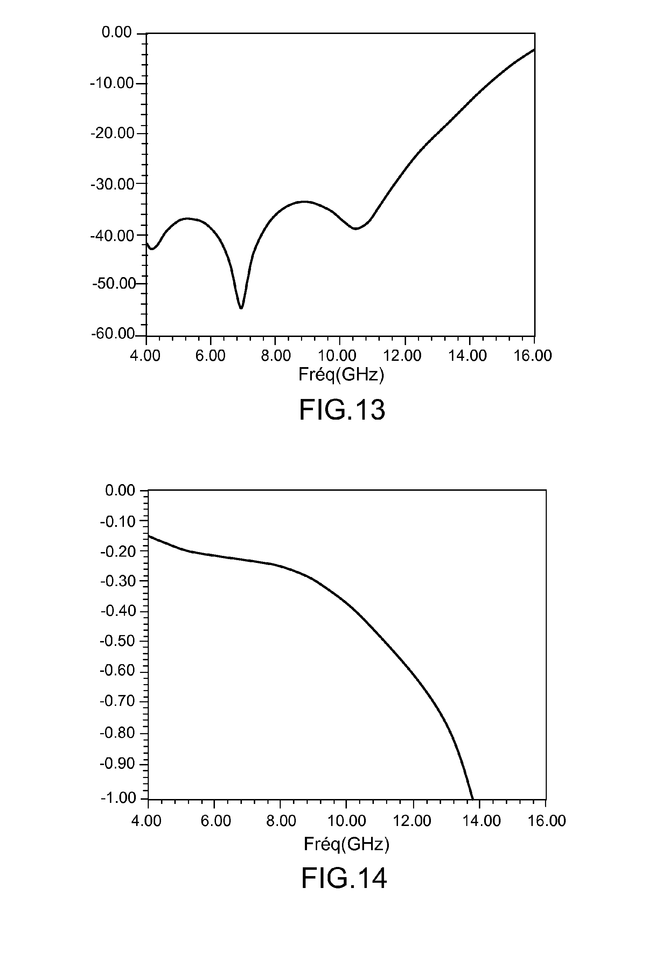

Un autre paramètre dimensionnel sur lequel on peut agir pour améliorer la transparence de l'interconnexion est le diamètre des vias 20 et 21 en cascade. La figure 13 représente une simulation du niveau d'adaptation S11 et la figure 14 représente une simulation du niveau d'insertion S21 pour l'interconnexion représentée sur la figure 9, dans laquelle le diamètre des vias 20 et 21 est de 500µm pour une distance d séparant les vias 20 et 21 de 200µm. Pour la fréquence de 9,3GHz, le niveau d'adaptation est de -34dB et les pertes d'insertion sont de 0,31 dB. On constate que les résultats sont bien meilleurs que pour les vias en parallèle pour lesquels de nombreuses simulations ont été réalisées sans obtenir de si bons résultats.

Avantageusement, le circuit imprimé comprend au moins un plan conducteur disposé entre les faces 11 et 12. Dans les exemples représentés sur les figures 6 et 9, le circuit imprimé comprend deux plans conducteurs 32 et 33 semblables aux plans 16 et 17 de la figure 1. Autour des vias 20 et 21, les deux plans conducteurs 32 et 33 sont interrompus pour former dans chacun une épargne, respectivement 34 et 35 au travers desquelles passent les vias 20 et 21. Les épargnes 34 et 35 ont chacune une forme oblongue dont des extrémités arrondies sont centrées sur des intersections des axes 24 et 25 des vias 20 et 21 avec les plans conducteur respectifs 32 et 33.

## Revendications

1. Circuit imprimé pour signaux haute fréquence, comprenant au moins deux faces (11, 12) portant chacune au moins une ligne de transmission (13, 14) des signaux et des moyens d'interconnexion (20, 21) des lignes de transmission (13, 14) entre les deux faces (11, 12),
**caractérisé en ce qu'**au voisinage des moyens d'interconnexion (20, 21), les lignes de transmission (13, 14) s'étendent chacune selon une direction principale (22, 23),
**en ce que** les moyens d'interconnexion comprennent deux vias (20, 21) s'étendant chacun selon un axe (24, 25), une ligne de transmission (13) d'une face (11) étant reliée à une ligne de transmission (14) d'une autre face (12) au moyen des deux vias (20, 21),
**en ce que** dans un plan (30) contenant la direction principale (22, 23) d'une première (13) des lignes de transmission (13, 14) et perpendiculaire à la face (11) portant la première ligne de transmission (13), on forme un repère orthogonal dont l'abscisse est porté par la direction principale (22) de la première ligne de transmission (13),
et **en ce que** les abscisses des axes (24, 25) des vias (20, 21) ou de leur projection sur le plan (30), perpendiculairement au plan (30), sont distinctes.

2. Circuit imprimé selon la revendication 1, **caractérisé en ce que** les directions principales (22, 23) des lignes de transmission (13, 14) reliées par les moyens d'interconnexion (20, 21) sont parallèles.

3. Circuit imprimé selon l'une des revendications précédentes, **caractérisé en ce qu'**il comprend au moins un plan conducteur (32, 33) disposé entre les faces (11, 12), **en ce que** le plan conducteur (32, 33) contient une épargne (34, 35) autour des vias (20, 21) et **en ce que** l'épargne (34, 35) a une forme oblongue dont des extrémités arrondies sont centrées sur des intersections des axes (24, 25) des vias (20, 21) avec le plan conducteur (32, 33).

4. Circuit imprimé selon l'une des revendications précédentes, **caractérisé en ce que** les vias (20, 21) sont à section circulaire perpendiculairement à leur axe respectif (24, 25).
